(19) Europäisches Patentamt
European Patent Office
Office européen des brevets

(11) Numéro de publication : **0 434 527 B1**

# (12) FASCICULE DE BREVET EUROPEEN

(45) Date de publication du fascicule du brevet : **14.07.93 Bulletin 93/28**

(51) Int. Cl.$^5$ : **H03L 7/197**

(21) Numéro de dépôt : **90403602.7**

(22) Date de dépôt : **14.12.90**

## (54) Synthétiseur hyperfréquence à division fractionnaire.

(30) Priorité : **22.12.89 FR 8917080**

(43) Date de publication de la demande : **26.06.91 Bulletin 91/26**

(45) Mention de la délivrance du brevet : **14.07.93 Bulletin 93/28**

(84) Etats contractants désignés : **DE GB IT**

(56) Documents cités :
**EP-A- 0 147 307**
**GB-A- 2 021 338**
**US-A- 4 034 309**

(73) Titulaire : **THOMSON-CSF**
**51, Esplanade du Général de Gaulle**
**F-92800 Puteaux (FR)**

(72) Inventeur : **Molina, Jacques**
**THOMSON-CSF SCPI Cédex 67**
**F-92045 Paris la Défense (FR)**
Inventeur : **Roullet, André**
**THOMSON-CSF SCPI Cédex 67**
**F-92045 Paris la Défense (FR)**
Inventeur : **La Rosa, Jean-Pierre**
**THOMSON-CSF SCPI Cédex 67**
**F-92045 Paris la Défense (FR)**

(74) Mandataire : **Lincot, Georges et al**
**THOMSON-CSF, SCPI, B.P. 329, 50, rue Jean-Pierre Timbaud**
**F-92402 Courbevoie Cédex (FR)**

EP 0 434 527 B1

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue Saint-Denis, 75001 PARIS

## Description

La présente invention concerne un synthétiseur hyperfréquence à division fractionnaire.

Elle s'applique notamment à la réalisation de synthétiseurs pour les systèmes de radiocommunication à haut débit de transmission, connus sous les désignations anglo-saxonnes TDMA et TACAN, où TDMA est l'abréviation de "Time division multiple access" et TACAN est l'abréviation de "Tactical Air Navigation".

Typiquement les synthétiseurs TDMA sont des synthétiseurs à temps d'acquisition très court de 15µs au pas de 3 MHz, qui sont utilisés pour l'émission et la réception d'informations dans la bande de fréquence 1242 à 1479 MHz. Par contre, les synthétiseurs TACAN sont des synthétiseurs à temps d'acquisition lent de 1ms au pas de 1MHz, qui sont utilisés pour l'émission d'informations dans la bande de fréquence 1025 à 1150 MHz et pour la réception d'informations dans la bande 1223 à 1474 MHz.

Dans les synthétiseurs de fréquence à division fractionnaire connus tel que celui décrit dans la demande de brevet EP 0 147 307 déposée au nom de la Demanderesse, le rang de division n'est pas fixe mais varie entre les rangs N et N+1 selon une loi calculée en temps réel, ce qui permet d'obtenir un pas élémentaire de fréquence sous-multiple de la fréquence de référence. Cette division s'effectue généralement en considérant M périodes de référence, durant lesquelles il y a F divisions par N+1 et (M-F) divisions par N. On obtient de la sorte un rang de division moyen Nm tel que :

$$Nm = (F(N + 1) + (M - F)N)/M = N + F/M \quad (1)$$

La fréquence synthétisée $F_S$ s'écrit alors en fonction de la fréquence de référence $F_R$ :

$$F_S = (N + F/M)F_R = (NM + F)F_R/M \quad (2)$$

Ce principe de synthèse introduit au niveau du comparateur de phase du synthétiseur, une erreur de phase cyclique provoquant une modulation de fréquence de l'oscillateur contrôlé en tension, et la fréquence de modulation est égale au décalage de fréquence fractionnaire. Cette modulation est annulée habituellement au moyen d'un dispositif de compensation actif qui corrige l'erreur de phase. Cependant ce dispositif n'est pas applicable aux synthétiseurs des applications TDMA car s'il permet d'atténuer fortement les raies de fractionnement, il n'est pas compatible du temps d'acquisition recherché. En effet, si le temps de commutation reste acceptable pour un petit saut de fréquence il ne l'est plus pour les sauts plus importants. Cela est dû essentiellement aux saturations successives qui se produisent dans l'amplificateur intégrateur de boucle durant la phase d'asservissement.

C'est pourquoi les solutions connues mises en oeuvre pour réaliser ces synthétiseurs font généralement appel aux techniques de synthèse de fréquence directe ou indirecte.

Un exemple connu de technique de synthèse de fréquence directe qui est dans son principe basée sur la commutation de 4 oscillateurs asservis, dont les fréquences sont additionnées et divisées répétitivement de façon à obtenir le pas recherché, permet d'obtenir un temps de commutation des fréquences utilisées très inférieur à 15 µs. Cependant, cette technique impose l'utilisation de composants coûteux et volumineux pour la réalisation des circuits mélangeurs et diviseurs de fréquence ainsi que celle des filtres successifs et les nombreuses raies parasites qui sont générées par ce type de réalisation ne conduisent pas à retenir cette solution. Pour les mêmes raisons le principe de synthèse directe à sélection et mélange d'harmoniques connu utilisant des filtres à onde de surface SAW ne peut non plus être adopté.

Dans la technique de la synthèse indirecte un principe de synthèse connu à deux boucles à verrouillage de phase, utilisant une boucle "pas gros" et une boucle "pas fin" avec prépositionnement d'oscillateur ainsi qu'un oscillateur de transposition permet théoriquement d'obtenir le temps d'acquisition recherché mais il conduit à un synthétiseur trop volumineux et trop consommant pour les applications envisagées.

Le but de l'invention est de pallier les inconvénients précités.

A cet effet, l'invention a pour objet, un synthétiseur hyperfréquence à division fractionnaire du type comprenant un oscillateur commandé en tension couplé à une première entrée d'un comparateur phase-fréquence par l'intermédiaire d'un diviseur de fréquence à rang variable pour comparer la fréquence et la phase du signal fourni par la sortie du diviseur de fréquence à rang variable à la fréquence et à la phase d'un signal de référence appliqué sur une deuxième entrée du comparateur phase-fréquence, délivrant respectivement sur une première sortie UP une première suite et sur une deuxième sortie DOWN une deuxième suite d'impulsions en fonction respectivement de l'avance ou du retard de phase des signaux appliqués sur sa première et sa deuxième entrée, les deux suites d'impulsions étant délivrées simultanément, en phase l'une avec l'autre, de même largeur et en phase avec le signal de référence lorsque les signaux appliqués sur les première et deuxième entrées du comparateur sont en phase un dispositif de commande pour asservir la fréquence d'oscillation de l'oscillateur commandé en tension sur une fréquence multiple entier et/ou fractionnaire de la fréquence ($F_R$) du signal de référence en fonction du rang de division du diviseur de fréquence à rang variable comprenant une capacité d'intégration chargée et déchargée respectivement par les impulsions de l'une ou l'autre suite, pour fournir en fonction de la tension développée aux bornes de la capacité un signal de commande d'avance ou de retard en fréquence et en phase de l'oscillateur, et comportant deux sources de courant commutées par les sorties UP et DOWN du comparateur de phase pour charger et décharger la capacité d'intégration lorsque respectivement l'une ou l'autre des deux suites d'impulsions est présente à la sortie du comparateur de phase caractérisé en ce que les deux sources de courant comportent deux voies UP et DOWN symétriques composées chacune d'une première paire différentielle de transistors qui effectue une translation de niveau pour commander une deuxième paire de transistors qui effectue la commutation du courant de charge et/ou de décharge de la capacité d'intégration et un circuit accumulateur de phase pour commander le rang de division du diviseur de fréquence à rang variable.

L'invention a pour avantage qu'elle permet de réaliser un synthétiseur ne comportant qu'une seule boucle à verrouillage de phase qui possède de ce fait un encombrement réduit, et dans lequel le choix de la fréquence de référence qui détermine la rapidité d'acquisition est indépendant du pas de fréquence. D'autre part, l'architecture obtenue se prête à la miniaturisation du synthétiseur car elle permet d'intégrer toutes les fonctions logiques sur un même substrat en mettant en oeuvre une technologie ECL peu consommante d'énergie et en hybridant les parties analogiques.

Enfin, l'utilisation d'un réseau de circuits réjecteurs passifs à la sortie du comparateur de phase, et d'un diviseur fractionnaire à rang de division faible permet de remplacer efficacement le dispositif de compensation utilisé habituellement pour corriger l'erreur de phase inhérente au principe de la division fractionnaire qui provoque une modulation de fréquence de l'oscillateur commandé en tension.

D'autres caractéristiques et avantages de l'invention apparaîtront ci-après à l'aide de la description qui suit faite en regard des dessins annexés qui représentent:

- la figure 1, un schéma synoptique d'un synthétiseur selon l'invention;
- la figure 2, un mode de réalisation du diviseur à rang variable de la figure 1;
- la figure 3, un mode de réalisation du prédiviseur de la figure 2;
- la figure 4, un diagramme de temps représentant le fonctionnement du prédiviseur de la figure 3;
- la figure 5, un diagramme de temps représentant le fonctionnement du diviseur à rang variable de la figure 2;
- la figure 6, un mode de réalisation de l'accumulateur de phase de la figure 1;
- la figure 7, un mode de réalisation du diviseur de référence de la figure 1;
- la figure 8, un mode de réalisation du comparateur phase fréquence de la figure 1;
- les figures 9A et 9B, deux graphes des temps illustrant le fonctionnement du comparateur phase fréquence de la figure 8.
- la figure 10, un mode de réalisation d'un dispositif de détection de verrouillage de phase;
- la figure 11, un tableau pour illustrer le fonctionnement du dispositif de la figure 10;
- la figure 12, un mode de réalisation de l'interface de gestion des données du synthétiseur représenté à la figure 1;
- les figures 13A et 13B, deux modes de réalisation de l'amplificateur charge-pompe et du filtre de boucle de la figure 1;
- la figure 14, le couplage des amplificateurs de sortie et de boucle du synthétiseur à la sortie de l'oscillateur commandé en tension de la figure 1;
- les figures 15A et 15B les formats des mots de commande du synthétiseur.

Le synthétiseur de fréquence à division fractionnaire qui est représenté à la figure 1 comprend, un oscillateur commandé en tension 1 couplé par sa sortie à un circuit diviseur de boucle à rang variable 2 au travers d'amplificateurs séparateurs 3. Il comprend également un diviseur de fréquence de référence 4, un comparateur phase-fréquence 5, un dispositif de commande d'asservissement 6 composé d'un circuit amplificateur 7 et d'un filtre de boucle 8, un circuit accumulateur de phase 9 et un circuit d'interface de gestion de données 10.

Le circuit diviseur de boucle à rang variable 2 qui est représenté à la figure 2 comprend, un circuit prédiviseur 11 à deux modulo Q/Q+1 et deux compteurs synchrones programmables 12 et 13 couplé à la sortie du circuit prédiviseur 11. Le circuit prédiviseur 11 comporte de la façon représentée à la figure 3, un ensemble de bascules montées en anneau de Johnson dans lesquelles seuls Q+1 états sont conservés pour permettre la réalisation d'un diviseur à deux modulo Q et Q+1.

Dans l'exemple de la figure 3, le nombre des bascules est limité à 4 et les bascules 14 et 16 forment un anneau à 8 états possibles. Un prédiviseur à deux module 4/5 est réalisé à l'aide des bascules 14, 15 et 16. La bascule 17 permet d'effectuer une extension double des modulo, c'est-à-dire, de réaliser une division par 8 ou par 9.

Le signal à diviser fourni par la sortie des amplificateurs (fig. 1) est appliqué sur les entrées d'horloge CK des bascules 14, 15 et 16 au travers de deux circuits d'interface 18 et 19 montés en série. Le mode de division modulo Q ou Q+1 est déterminé par les circuits logiques "ou" 20, 21 et 22 placés sur les rebouclages successifs des sorties des bascules 16, 15 et 14 sur l'entrée de la bascule 14.

Les sorties du prédiviseur 11 sont sélectionnées par des circuits "ou" 24 et 25 commandés à partir d'un bit de commande MS/SP appliqué sur l'entrée d'un circuit inverseur 23. Ainsi, en mode de division 4/5 la

sortie $Q_1$ de la première bascule 14 constitue le signal de sortie du prédiviseur et la sortie de la dernière bascule 17 est inhibée dans ce cas. Un chronogramme illustrant le fonctionnement du prédiviseur est représenté à la figure 4. Celui-ci représente les états successifs des sorties $Q_1$ à $Q_4$ des bascules 14 à 17 en fonction des états H du signal de fréquence $F_S$ fourni par l'oscillateur de la figure 1 au travers des amplificateurs 3.

Les deux compteurs 12 et 13 représentés sur la figure 2 reçoivent le signal d'horloge H divisé par Q ou Q+1 issu du prédiviseur 11. Ces compteurs sont programmés aux valeurs respectives $N_A$ et $N_P$ et décomptent simultanément à partir de ces valeurs, au début du cycle de division par Q+1, tant que le nombre $N_A$ n'a pas été décompté à zéro par le compteur 12. Lorsque cela se produit, le décomptage du compteur 12 est arrêté et le rang de division du prédiviseur 11 est positionné sur Q par la sortie d'un décodeur 26 de l'état "O" qui commande l'inhibition du compteur 12 (entrée E), et le chargement du mode de division du prédiviseur 11. A cet instant il y a $(Q+1) \times N_A$ impulsions d'horloge comptées. Le décomptage du nombre Np par le compteur 13 se poursuit jusqu'à atteindre l'état "2" décodé par un décodeur 27 formé par une porte "non ou "ou tout dispositif équivalent placé à la sortie du compteur 13.

Le décodage de l'état 2 constitue une information de fin de cycle de division. Celle-ci est synchronisée sur le front montant de l'horloge de sortie du prédiviseur 11 et commande le rechargement des compteurs 12 et 13 par l'intermédiaire d'une bascule 28, en synchronisme avec cette horloge, aux valeurs initiales $N_A$ et $N_P$. Le compteur 12 se débloque, le prédiviseur 11 est positionné pour diviser par Q+1 et le cycle recommence. Le nombre total d'implusions d'horloge d'entré H comptées au cours d'un cycle de division est:

$$N = (Q + 1) \times N_A + (N_p - N_A)Q = QN_p + N_A$$

en mode 8/9 on obtient $N = 8N_p + N_A$ et en mode 4/5 on obtient $N = 4N_p+N_A$

Pour que le fonctionnement soit possible et s'effectue sans ambiguïté il faut que la relation :

$N_p - N_A > 0$ soit vérifiée, d'où $N_p\min = N_A\max$. Avec par exemple, $0 \leqq N_A \leqq 7$, la valeur minimale que peut prendre N est alors :

$Nmin = 8N_p\min + N_A\min = 56$

Si le prédiviseur 11 est utilisé en mode 4/5 on aurait pour $0 \leqq N_A \leqq 3$, Nmin = 12

Un mode de séquencement des états pour un cycle de division correspondant à N=119 et montré à la figure 5.

Le diviseur de référence 4 permet d'obtenir une fréquence de référence $F_R$ de la boucle, sous-multiple de la fréquence de référence externe. Son rang de division est programmé par un mot de commande de 5 bits RØ à R4.

Le diviseur de la fréquence de référence est constitué de la manière représentée à la figure 7 par un compteur binaire 5-bit programmable 30 qui fournit tous les rangs de division compris entre 2 et 32 inclus. Ce circuit décompte de la valeur programmée sur ses entrées D jusqu'à la valeur "zéro", en synchronisme avec le front montant d'un signal d'horloge fourni par une fréquence de référence externe). Une porte de décodage 31 disposée en sortie du compteur 30 détecte l'état "0" et envoie un niveau "0" sur l'entrée "LOAD" du compteur 30 ce qui, autorise son rechargement à la valeur programmée sur ses entrées D.

Lorsque la commande R du rang de division du diviseur de référence 4 est égale à "0", cet état est détecté par une porte de décodage 32 au travers d'un circuit d'interface 34 qui envoie un signal de commande permettant de sélectionner la voie Do d'un multiplexeur à 2 entrées. Le signal "référence externe" est appliqué sur l'entrée Do d'un multiplexeur 33 au travers d'un circuit de mise en forme 35 et le signal de sortie du compteur 30 sur l'entrée D1 de ce même multiplexeur 33 au travers de la porte de décodage 31.

Ce dispositif permet lorsque le rang de division est nul (R=0) d'avoir une fréquence de référence de boucle FR égale à la fréquence de référence externe.

Pour le synthétiseur TDMA la fréquence de référence qui est de 12 MHz est obtenue après division par 2 de la fréquence de référence externe 24 MHz. La fréquence de référence de boucle du synthétiseur TACAN est de 1 MHz ; elle est obtenue après division par 24 de cette même fréquence de référence externe.

Le circuit accumulateur de phase 9 qui est représenté à la figure 6 comprend un circuit additonneur 36 (3 bits) suivi d'une registre 37 (4 bits) qui permet de synchroniser sur le front montant de l'horloge, à la fréquence de référence $F_R$, les informations obtenues en sortie du circuit additionneur 36 avec le signal de débordement $C_{OUT}$ du registre 37. Les sorties ($Q_1$ - $Q_3$) du registre 37 sont rebouclées sur les entrées ($B_O$ - $B_2$) du circuit additionneur 36.

Le rôle du circuit accumulateur de phase 9 est de déterminer à chaque cycle de référence défini par la période du signal fourni par le diviseur de fréquence de référence 5 le mode de division par N ou par N+1 du circuit diviseur de boucle à rang variable.

Le module M du circuit accumulateur de phase 4 est lié à la fréquence de référence $F_R$ et au pas P du synthétiseur par la relation :

$$M = F_R/P$$

Les informations de commande en fréquence du synthétiseur sont fournies par le rang de division N utilisé lors de la programmation du diviseur à rang variable 2 et par le terme fractionnaire F appliqué à l'entrée du circuit accumulateur de phase 4 qui est défini suivant la relation (2) par la relation :

$$F = M (F_S/F_R - N) \quad (4)$$

Le contenu du registre 37 est augmenté du nombre F à chaque période $1/F_R$ du signal de référence.

Le contenu $P_k$ du registre de l'accumulateur 37 est de la sorte égal, à la Kième période d'horloge à $P_k = (P_{k-1}+F)$ modulo M (5).

La valeur maximale de $P_k$ étant M-1.

Lorsque le contenu du registre 37 atteint ou dépasse la valeur M, le circuit accumulateur 37 fournit un signal de débordement qui est appliqué sur l'entrée de retenue cin du circuit additionneur 29 pour commander l'incrémentation du rang de division N d'une unité. (commande N,N+1 sur les figures 1 et 2).

Les valeurs successives du contenu $P_k$ du registre accumulateur 37 correspondent à la différence de phase qui existe entre le signal de boucle $F_S/N$ et la fréquence de référence $F_R$.

Le circuit comparateur phase-fréquence 5 mesure l'écart de fréquence entre le signal de sortie du diviseur à rang variable de fréquence $F_S/N$ et le signal de référence de fréquence $F_R$ pendant la période transitoire d'asservissement de la boucle lors d'un changement de fréquence.

Lorsque la boucle est stabilisée le circuit comparateur 5 fournit à chaque période de référence $1/F_R$ une mesure de l'écart de phase entre les signaux $F_S/N$ et $F_R$.

Ce circuit comprend deux bascules de "type D", 38, 39 couplées à deux circuits multiplexeurs 40, 41. Les bascules 38, 39 sont activées sur le front montant de l'horloge $C_p$, et leurs sorties Q sont rebouclées sur les entrées "Reset" par l'intermédiaire d'une porte "non ou" 42.

Pendant la phase transitoire d'asservissement de la boucle il n'y a plus aucune relation de phase entre les signaux à l'entrée du comparateur 5, les sorties Q des bascules 38 et 39 délivrent respectivement une information d'avance "UP" ou de retard de phase "DOWN" d'un signal par rapport à l'autre.

Lorsque la boucle est stabilisée, les signaux de sortie "UP", "DOWN" du comparateur 5 sont constitués par une suite d'impulsions très fines de période égale à celle du signal de référence appliqué à l'entrée du comparateur. Ces impulsions en sorties "UP" et "DOWN" sont en phase. Des graphes du fonctionnement correspondant du circuit comparateur sont représentés aux figures 9A et 9B.

Comme les performances du synthétiseur, notamment en ce qui concerne sa pureté spectrale, sont mesurées lorsque la boucle est verrouillée, c'est-à-dire, lorsque le comparateur fonctionne au voisinage de l'écart de phase nul, la caractéristique de transfert du circuit comparateur 5 doit être très linéaire dans cette plage et sans zone morte de façon à maintenir constant le gain du circuit comparateur de phase 5 et donc le gain de la boucle de phase.

Les multiplexeurs 40 et 41 à 2 entrées permettent de permuter les signaux à l'entrée du comparateur en fonction du signal de commande CPF. Ce dispositif permet d'inverser le sens de commande de l'oscillateur 1.

Le circuit comparateur phase fréquence 5 est complété utilement par un dispositif de détection à verrouillage de boucle représenté à la figure 10 où les éléments du circuit comparateur 5 homologues à ceux de la figure 8 sont représentés avec le mêmes références.

Ce dispositif fournit une information fiable permettant de détecter tout mauvais fonctionnement du synthétiseur. Pour cela il exploite les signaux "UP" et "DOWN" apparaissant en sortie du circuit comparateur 5 et délivre un état logique "1" lorsque la boucle de phase est verrouillée, ou un état "0" dans le cas contraire.

En fonction de la situation de la boucle de phase différents signaux peuvent apparaître en sortie du circuit comparateur phase-fréquence 5. Ces différents cas sont résumés dans le tableau de la figure 11.

Sur la figure 10 les signaux "UP" et "DOWN" en sortie du circuit comparateur 5 sont envoyés à l'entrée d'un circuit "ou exclusif" 43. Ils sont constitués lorsque la boucle n'est pas verrouillée, soit d'un niveau "1" soit d'une succession de "0" et de "1" avec une forte proportion de "1". Le signal de sortie du circuit "OU" 44 est appliqué à l'entrée MR de remise à zéro d'un compteur 45 qui a pour horloge la fréquence de référence FR. Lorsque la sortie du circuit "OU" 44 est dans l'état "1" permanent (MR=1), les sorties Q du compteur 45 qui sont réunies à l'entrée d'une porte "NON OU" 46 délivrent un état "1".

S'il s'agit d'une succession d'états "1", le compteur 45 est réinitialisé fréquemment et présente en sortie du circuit "NON OU" 46 un état "1" permanent, car il n'a pas dans ce cas le temps de terminer son comptage. Cet état est inversé par l'amplificateur 47 avant d'être transmis à la sortie du dispositif de détection.

Lorsque la boucle est verrouillée, les impulsions d'équilibre présentes sur les sorties Q du compteur 45 sont en phase et l'entrée MR du compteur 45 passe à l'état "0". Un filtre 48 disposé en sortie du circuit "ou exclusif" 43 permet de lisser les impulsions parasites pouvant apparaître lors des transitions des impulsions d'équilibre. Ce filtre est constitué par un condensateur CL. Lorsque l'entrée MR=0 le compteur 45 compte 15 périodes d'horloge de référence. En fin de comptage, il fournit un état "0" en sortie du circuit "non ou" 46 qui réunit les sorties Q du compteur 45, ce qui bloque le comptage (du fait du rebouclage sur l'entrée d'inhibition d'horloge $\overline{CEP}$ du compteur). Cet état est transmis en sortie du système de détection par l'amplificateur 47.

Comme pour un saut de fréquence de faible amplitude (1 à 2 pas de fréquence par exemple), la boucle réagit très vite et les impulsions d'équilibre en sortie du comparateur de phase 5 ne sont pas suffisamment perturbées pour être détectées par ce dispositif ; le circuit "OU" 44 applique à l'entrée MR du compteur 45 un signal $CHF_2$, provenant de l'interface de gestion des données 10.

Le signal $CHF_2$ de déclencher le comptage et d'indiquer le déverrouillage de la boucle lors de la phase d'asservissement.

Le dispositif de commande d'asservissement, représenté respectivement pour les applications TDMA et TACAN aux figures 13A et 13B, comprend, un amplificateur charge-pompe 7, couplé à des filtres de boucle 48 et réjecteurs 49 et à un filtre passe-bas 50 reliés en série.

L'amplificateur charge-pompe 7 est constitué par deux sources de courant $I_{UP}$ et $I_{DOWN}$ commutées, formées des transistors 50 à 57 qui chargent et déchargent une capacité d'intégration 62. Les deux sources de courant comportent deux voies UP et DOWN symétriques composées chacune d'une première paire différentielle de transistors 50, 51 respectivement 52, 53 qui effectue une translation de niveau pour commander une deuxième paire 54, 55 respectivement 56, 57 de transistors qui effectue la commutation du courant de charge et/ou de décharge de la capacité d'intégration 62. La commande de commutation est assurée par les signaux de sortie "UP" et "DOWN" et leur complément fournis par le comparateur 5. La rapidité des commutateurs dont chacun est constitué par un étage différentiel à transistors permet de prendre en compte les impulsions fines en sortie du comparateur de phase 5.

Le gain de conversion de l'ensemble comparateur de phase et amplificateur charge-pompe 7 est défini par la valeur du courant de sortie qui est optimisé en fonction du gain de boucle et de la rapidité de réponse recherchée.

Le filtre de boucle 48 formé de la résistance 60 et des capacités 61 et 62 est déterminé de façon à obtenir les caractéristiques de bruit de phase et de temps d'acquisition recherchées.

A titre d'exemple, un synthétiseur lent type TACAN doit pouvoir disposer d'une bande passante de boucle étroite (fréquence de coupure 30 KHz), et un synthétiseur rapide type TDMA doit disposer d'une bande passante de boucle large (fréquence de coupure 400 KHz).

Les raies parasites multiples de la fréquence de référence sont éliminées au moyen de filtres réjecteurs 49 pour le TACAN et 66 pour le TDMA formés par des éléments résonnants séries centrés, par exemple, sur la fréquence 12MHz pour la réalisation des synthétiseurs TDMA et 1MHz pour la réalisation de synthétiseurs TACAN.

Les autres raies harmoniques de la fréquence de référence sont filtrées par la boucle.

Pour le synthétiseur TDMA, les raies de fractionnement aux fréquences multiples de 3MHz sont éliminées au moyen de filtres réjecteurs 63,64,65 centrés sur les fréquences de 3MHz, 6MHz et 9MHz. Les autres raies harmoniques de 3 MH et de fréquence supérieure à 12MHz ne nécessitent pas de filtrage spécifique car elles sont déjà fortement atténuées par le filtrage de boucle.

Les raies à 3 et 6MHz qui sont les plus proches de la bande passante de boucle nécessitent chacune pour être ramenée à un niveau inférieur à -70$dB_c$ deux réjecteurs à self L et capacité C (un circuit bouchon 63 bis LC série suivi d'un circuit LC parallèle pour atténuer les raies à 3MHz et deux circuits parallèle 64, 64 bis pour atténuer les raies à 6MHz).

Deux circuits LC parallèles centrés à 9 MHz et 12 MHz permettent d'atténuer les raies à ces fréquences.

L'interface de gestion de données qui est représentée à la figure 12, gère les informations de commande du synthétiseur fournies par le bus radio CR de la figure 1, pour les modes de fonctionnement spécifique des synthétiseurs TDMA et TACAN. Dans cet exemple, l'information de commande du synthétiseur TDMA est composé d'un mot de 8 bits parallèle dont 6 sont utilisés pour définir le numéro du canal de fréquence (compris entre 0 et 50) sur lequel doit fonctionner le synthétiseur.

Les informations sont prises en compte sur le front montant de l'impulsion du signal $CHF_1$ qui constitue l'horloge d'un registre 67 validé par le niveau bas du signal ENABLE.

L'information de canal CR est appliquée sur un circuit d'interface 72 et est transformée en information de commande du diviseur à rang variable 2 (mots $N_A$ sur 3 bits et $N_p$ sur 8 bits dans cet exemple pour la programmation des compteurs 12 et 13 figure 2) et du circuit accumulateur de phase 9 (mot F sur 3 bits) par l'intermédiaire d'un circuit de codage 68 relié au registre 67.

De même l'information de commande d'un synthétiseur TACAN est constituée dans cet exemple par deux mots série de 8 bits parallèles dont le format est représenté aux figures 15A et 15B.

Les informations contenues dans ces deux mots permettent de commander directement le diviseur à rang variable 2 (mots $N_A$ et $N_p$ respectivement sur 3 et 8 bits pour la programmation des compteurs 12 et 13), du circuit accumulateur de phase 9 (mot F sur 3 bits) et la permutation des entrées du comparateur de phase (mot CPF sur 1 bit).

En mode TACAN les bits D0 à D4 formant le 2ème mot pourront tous avoir la valeur 0.

Le premier mot de 8 bits est pris en compte sur le front montant de la première impulsion du signal $CHF_1$ par le registre 67 sous le contrôle d'une porte 73. Le deuxième mot de 8 bits est pris en compte sur le front montant de la deuxième impulsion du signal $CHF_1$ par un registre 69 sous le contrôle d'une porte 74. Un signal REGISTER SELECT combiné avec le signal ENABLE permet de valider successivement les registres 67 et 69. Un registre tampon 70 est validé en même temps que le registre 69 afin de transférer vers une entrée 16 bits d'un multiplexeur 71, le premier mot de 8 bits simultanément avec le deuxième mot, sur le front montant de la deuxième impulsion du signal $CHF_1$. A cette fin, le multiplexeur 71 reçoit sur sa deuxième entrée 16 bits, les informations TDMA en sortie du circuit de codage 68. Ceci a pour avantage de permettre de sélectionner, à partir d'une commande câblée TDMA/TACAN, les informations de commande du synthétiseur pour le mode TDMA ou le mode TACAN. Le circuit d'interface comprend également un séquenceur 75 bis, qui délivre un signal $CHF_2$ pour sélectionner la deuxième impulsion du signal $CHF_1$ en mode TACAN. Ainsi réalisée l'interface de gestion des données peut fonctionner par exemple avec une fréquence d'horloge de 5 MHz.

Enfin le couplage des amplificateurs 3 de la sortie et de la boucle du synthétiseur à la sortie de l'oscillateur 1 est réalisé comme le montre la figure 14 au moyen d'amplificateurs référencés 75 à 77, les amplificateurs 76 et 77 réalisant la séparations des deux voies (de sortie et de boucle).

Pour l'application TDMA, l'oscillateur 1 doit pouvoir couvrir la bande de fréquence 1242-1479 MHz en conservant une caractéristique de transfert tension-fréquence très linéaire pour conserver un gain de boucle constant et des performances de pureté spectrale du synthétiseur dans toute la plage de fréquence.

Pour un synthétiseur TACAN, l'oscillateur doit être à même de couvrir des bandes de fréquence Emission et Réception de 1025 à 1474 MHz. La plage de fréquence couverte par cet oscillateur est par conséquent plus importante que celle couverte par l'oscillateur de l'application TDMA, mais dans ce cas il n'est pas nécessaire d'avoir une linéarité aussi élevée car la conservation des performances de pureté spectrale dans la gamme de fréquence est moins critique. On peut ainsi obtenir quelles que soient les applications un bruit plancher inférieur à -150 dBc/Hz à partir d'un écart de fréquence de ±10% de la fréquence centrale et un niveau de sortie de l'oscillateur de +13dBm.

## Revendications

1. Synthétiseur hyperfréquence à division fractionnaire du type comprenant un oscillateur commandé en tension (1) couplé à une première entrée d'un comparateur phase-fréquence (5) par l'intermédiaire d'un diviseur de fréquence à rang variable (2) pour comparer la fréquence et la phase du signal fourni par la sortie du diviseur de fréquence à rang variable (2) à la fréquence et à la phase d'un signal de référence appliqué sur une deuxième entrée du comparateur phase-fréquence (5), délivrant respectivement sur une première sortie UP une première suite et sur une deuxième sortie DOWN une deuxième suite d'impulsions en fonction respectivement de l'avance ou du retard de phase des signaux appliqués sur sa première et sa deuxième entrée, les deux suites d'impulsions étant délivrées simultanément, en phase l'une avec l'autre, de même largeur et en phase avec le signal de référence lorsque les signaux appliqués sur les première et deuxième entrées du comparateur (5) sont en phase, un dispositif de commande (8) pour asservir la fréquence d'oscillation de l'oscillateur commandé en tension (1) sur une fréquence multiple entier et/ou fractionnaire de la fréquence ($F_R$) du signal de référence en fonction du rang de division du diviseur de fréquence à rang variable (2) comprenant une capacité d'intégration (58) chargée et déchargée respectivement par les impulsions de l'une ou l'autre suite, pour fournir en fonction de la tension développée aux bornes de la capacité un signal de commande d'avance ou de retard en fréquence et en phase de l'oscillateur (1), et comportant deux sources de courant commutées (50 ; ... 57) par les sorties UP et DOWN du comparateur de phase (5) pour charger et décharger la capacité d'intégration (58) lorsque respectivement l'une ou l'autre des deux suites d'impulsions est présente à la sortie du comparateur de phase (5) et un circuit accumulateur de phase (9) pour commander le rang de division du diviseur de fréquence à rang variable (2) caractérisé en ce que les deux sources de courant comportent deux voies UP et DOWN symétriques composées chacune d'une première paire différentiele de transistors (50, 51 ; 52, 53) qui effectue une translation de niveau pour commander une deuxième paire de transistors (54, 55 ; 56, 57) qui effectue la commutation du courant de charge et/ou de décharge de la capacité d'intégration.

2. Synthétiseur selon la revendication 1 caractérisé en ce que le dispositif de commande d'asservissement (8) comprend des filtres réjecteurs de fréquence disposés entre la sortie des sources de courant commutées (50 ... 57) et la capacité d'intégration (58) pour éliminer les fréquences parasites à l'extérieur de la bande passante de la boucle.

3. Synthétiseur selon l'une quelconque des revendications 1 et 2 caractérisé en ce que le diviseur à rang variable (2) comporte deux rangs de division N et N+1 commandés par le signal de débordement du circuit accumulateur (9).

4. Synthétiseur selon la revendication 3 caractérisé en ce que le diviseur à rang variable (2) comporte un premier et un deuxième compteur programmable (12, 13), pilotés par un signal d'horloge fourni par un circuit prédiviseur (11) à deux modulo Q et Q+1 du signal d'horloge de fréquence $F_S$ fourni par l'oscillateur, les deux compteurs (12, 13) étant chargés en début de division aux valeurs respectives $N_A$ et $N_p$ et commandés pour décompter simultanément à partir des valeurs $N_A$ et $N_p$ durant $N_A(Q+1)$ impulsions jusqu'à l'impulsion pour laquelle le contenu du premier compteur (12) devient nul, et durant les $(N_p-N_A)Q$ impulsions restantes nécessaires pour vider de son contenu le deuxième compteur (13), le passage du rang de division Q+1 au rang de division Q du circuit prédiviseur (11) étant commandé par l'annulation du contenu du premier compteur (12).

**5.** Synthétiseur selon l'une quelconque des revendications 1 à 4 caractérisé en ce que la fréquence de référence est obtenue à partir d'un diviseur de référence (4) programmable.

**6.** Synthétiseur selon l'une quelconque des revendications 1 à 5 caractérisé en ce que le comparateur phase fréquence comprend un détecteur numérique de verrouillage (43 ... 47).

**7.** Synthétiseur selon la revendication 6 caractérisé en ce que le détecteur numérique de verrouillage comporte un compteur (45) remis à zéro pour la sortie d'un circuit "OU exclusif" à deux entrées (43) reliées respectivement aux sorties UP et DOWN du comparateur de phase (5), et incrémenté au rythme de l'horloge de référence $F_R$.

**8.** Synthétiseur selon l'une quelconque des revendications 1 à 7 caractérisé en ce qu'il comporte un circuit d'interface de gestion pour appliquer au synthétiseur les commandes de rang N entier et/ou fractionnaire F et la commande de permutation des entrées des comparateurs de phase fréquence.

**9.** Utilisation du synthétiseur selon l'une quelconque des revendications 1 à 8 aux transmissions TDMA et TACAN.

## Claims

**1.** Fractional division UHF synthesiser of the type comprising a voltage-controlled oscillator (1) coupled to a first input of a phase-frequency comparator (5) by means of a variable-rank frequency divider (2) for comparing the frequency and the phase of the signal supplied by the output of the variable-rank frequency divider (2) to the frequency and to the phase of a reference signal applied to a second input of the phase-frequency comparator (5), delivering respectively on a first UP output a first series and on a second DOWN output a second series of pulses as a function respectively of the phase advance or phase delay of the signals applied on its first and its second input, the two series of pulses being delivered simultaneously, in phase with one another, of the same width and in phase with the reference signal when the signals applied to the first and second inputs of the comparator (5) are in phase. A control device (8) for slaving the oscillation frequency of the voltage-controlled oscillator (1) to an integer and/or fractional multiple frequency of the frequency ($F_R$) of the reference signal as a function of the division rank of the variable-rank frequency divider (2) comprising an integration capacitor (58) charged and discharged respectively by the pulses of one or the other series, for supplying, as a function of the voltage developed at the terminals of the capacitor, a frequency and phase advance or delay control signal for the oscillator (1), and including two current sources switched (50;...57) by the UP and DOWN outputs of the phase comparator (5) in order to charge and discharge the integration capacitor (58) respectively when one or the other of the two series of pulses is present at the output of the phase comparator (5) and a phase accumulator circuit (9) for controlling the division rank of the variable-rank frequency divider (2), characterised in that the two current sources include two symmetrical UP and DOWN channels each composed of a first differential pair of transistors (50, 51; 52, 53) which carries out a level translation in order to control a second pair of transistors (54, 55; 56, 57) which carries out the switching of the charging and/or discharging current of the integration capacitor.

**2.** Synthesiser according to Claim 1, characterised in that the slaving control device (8) comprises frequency rejector filters arranged between the output of the switched current sources (50....57) and the integration capacitor (58) in order to eliminate the parasitic frequencies outside the pass band of the loop.

**3.** Synthesiser according to either of Claims 1 or 2, characterised in that the variable-rank divider (2) includes two division ranks N and N+1 controlled by the overflow signal from the accumulator circuit (9).

**4.** Synthesiser according to Claim 3, characterised in that the variable-rank divider (2) includes a first and a second programmable counter (12, 13), driven by a clock signal supplied by a two modulo Q and Q+1 pre-divider circuit (11) for the clock signal of frequency $F_S$ supplied by the oscillator, the two counters (12, 13) being loaded at the start of division to the respective values $N_A$ and $N_p$ and controlled in order simultaneously to count down from the values $N_A$ and $N_p$ during $N_A(Q+1)$ pulses down to the pulse for which the contents of the first counter (12) become zero, and during the $(N_p-N_A)Q$ remaining pulses necessary to empty the second counter (13) of its contents, the change from the division rank Q+1 to the division rank Q of the predivider circuit (11) being controlled by the cancellation of the contents of the first counter (12).

5. Synthesiser according to any one of Claims 1 to 4, characterised in that the reference frequency is obtained from a programmable reference divider (4).

6. Synthesiser according to any one of Claims 1 to 5, characterised in that the phase-frequency comparator comprises a digital locking detector (43...47).

7. Synthesiser according to Claim 6, characterised in that the digital locking detector includes a counter (45) reset to zero by the output of an "exclusive OR" circuit with two inputs (43) linked respectively to the UP and DOWN outputs of the phase comparator (5), and incremented at the rate of the reference clock $F_R$.

8. Synthesiser according to any one of Claims 1 to 7, characterised in that it includes a management interface circuit for applying, to the synthesiser, the controls of integer N and/or fractional F rank and the control of permutation of the inputs of the phase-frequency comparators.

9. Use of the synthesizer according to any one of Claims 1 to 8 for TDMA and TACAN transmissions.

**Patentansprüche**

1. Mikrowellensynthesierer mit einer Division mit gebrochenem Teiler, mit einem spannungsgesteuerten Oszillator (1), der an einem ersten Eingang eines Phasen-Frequenzkomparators (5) über einen Frequenzteiler variablen Rangs (2) gekoppelt ist, um die Frequenz und die Phase des vom Ausgang des Frequenzteilers mit variablem Rang (2) gelieferten Signals mit der Frequenz und der Phase eines an einem zweiten Eingang des Phasen-Frequenzkomparators (5) angelegten Bezugssignals zu vergleichen, wobei an einem ersten Ausgang UP eine erste und an einem zweiten Ausgang DOWN eine zweite Folge von Impulsen, abhängig von der Phasenvoreilung oder -nacheilung der an den ersten und den zweiten Eingang angelegten Signale geliefert wird, wobei diese beiden Impulsfolgen gleichzeitig und mit gleicher Phase geliefert werden und die gleiche Breite und die gleiche Phase wie das Bezugssignal besitzen, wenn die an den ersten und den zweiten Eingang des Komparators (5) angelegten Signale in Phase sind, mit einer Steuervorrichtung (8) zum Nachregeln der Schwingkreisfrequenz des spannungsgesteuerten Oszillators (1) auf ein ganzzahliges und/oder nicht ganzzahliges Vielfaches der Frequenz ($F_R$) des Bezugssignals abhängig vom Teilerrang des Frequenzteilers mit variablem Rang (2), mit einem Integrationskondensator (58), der durch die Impulse der einen oder anderen Folge geladen bzw. entladen wird, um abhängig von der an seinen Klemmen entwickelten Spannung ein Voreilungs- oder Nacheilungssteuersignal bezüglich Frequenz und Phase des Oszillators (1) zu liefern, und mit zwei umschaltbaren Stromquellen (50; ... 57), die von den Ausgängen UP und DOWN des Phasenkomparators (5) umgeschaltet werden, um den Integrationskondensator (58) zu laden und zu entladen, wenn die eine oder die andere der beiden Impulsfolgen am Ausgang des Phasenkomparators (5) vorliegt, und mit einem Phasenakkumulatorkreis (9), um den Teilerrang des Frequenzteilers mit variablem Rang (2) zu steuern, dadurch gekennzeichnet, daß die beiden Stromquellen zwei symmetrische Kanäle UP und DOWN besitzen, die je von einem ersten differentiellen Paar von Transistoren (50, 51; 52, 53) gebildet werden, das eine Pegelumsetzung bewirkt, um ein zweites Transistorpaar (54, 55; 56, 57) zu steuern, das die Umschaltung des Ladestroms und/oder des Entladestroms des Integrationskondensators bewirkt.

2. Synthesierer nach Anspruch 1, dadurch gekennzeichnet, daß die Vorrichtung zur Regelungssteuerung (8) Frequenzsperrfilter enthält, die zwischen dem Ausgang der umschaltbaren Stromquellen (50 ...57) und dem Integrationskondensator (58) angeordnet sind, um die Störfrequenzen außerhalb des Durchlaßbandes der Schleife zu eliminieren.

3. Synthesierer nach einem beliebigen der Ansprüche 1 und 2, dadurch gekennzeichnet, daß der Teiler mit variablem Rang (2) zwei Teilerränge N und N+1 besitzt, die vom Überlaufsignal des Akkumulatorkreises (9) gesteuert werden.

4. Synthesierer nach Anspruch 3, dadurch gekennzeichnet, daß der Teiler mit variablem Rang (2) einen ersten und zweiten programmierbaren Zähler (12, 13) enthält, die von einem von einem Vor-Teilerkreis (11) gelieferten Taktsignal gesteuert werden, der das vom Oszillator gelieferte Signal der Frequenz $F_S$ gemäß zwei Teilerrängen Q und Q+1 teilt, wobei die beiden Zähler (12, 13) zu Beginn der Division auf Werte $N_A$ bzw. $N_p$ eingestellt werden und dann zugleich, ausgehend von den Werten $N_A$ und $N_p$, während $N_A(Q+1)$ Impulsen rückwärts zählen, bis zum Impuls, bei dem der Inhalt des ersten Zählers (12) Null wird, und während der $(N_p-N_A)Q$ verbleibenden Impulsen, die zum Leeren des zweiten Zählers (13) erforderlich sind, wobei der Übergang des Teilerrangs Q+1 auf den Teilerrang Q des Vor-Teilerkreises (11) durch die Nullsetzung des ersten Zählers (12) gesteuert wird.

**5.** Synthesierer nach einem beliebigen der Ansprüche 1 bis 4, dadurch gekennzeichnet, daß die Bezugsfrequenz in einem programmierbarem Bezugsteiler (4) erhalten wird.

**6.** Synthesierer nach einem beliebigen der Ansprüche 1 bis 5, dadurch gekennzeichnet, daß der Phasen-Frequenzkomparator einen digitalen Verriegelungsdetektor (43 ... 47) enthält.

**7.** Synthesierer nach Anspruch 6, dadurch gekennzeichnet, daß der digitale Verriegelungsdetektor einen Zähler (45) enthält, der durch den Ausgang eines Exklusiv-ODER-Kreises (43) mit zwei Eingängen auf Null gesetzt wird, wobei diese beiden Eingänge an die Ausgänge UP und DOWN des Phasenkomparators (5) angeschlossen sind, und der im Rhythmus des Bezugstakts ($F_R$) zählt.

**8.** Synthesierer nach einem beliebigen der Ansprüche 1 bis 7, dadurch gekennzeichnet, daß er einen Verwaltungsschnittstellenkreis enthält, um an den Synthesierer die Steuerungen des ganzzahligen Rangs N oder des nicht ganzzahligen Rangs F und die Steuerung zur Permutierung der Eingänge der Phasen-Frequenzkomparatoren anzulegen.

**9.** Verwendung des Synthesierers nach einem beliebigen der Ansprüche 1 bis 8, auf Übertragungen vom Typ TDMA und TACAN.

FIG. 1

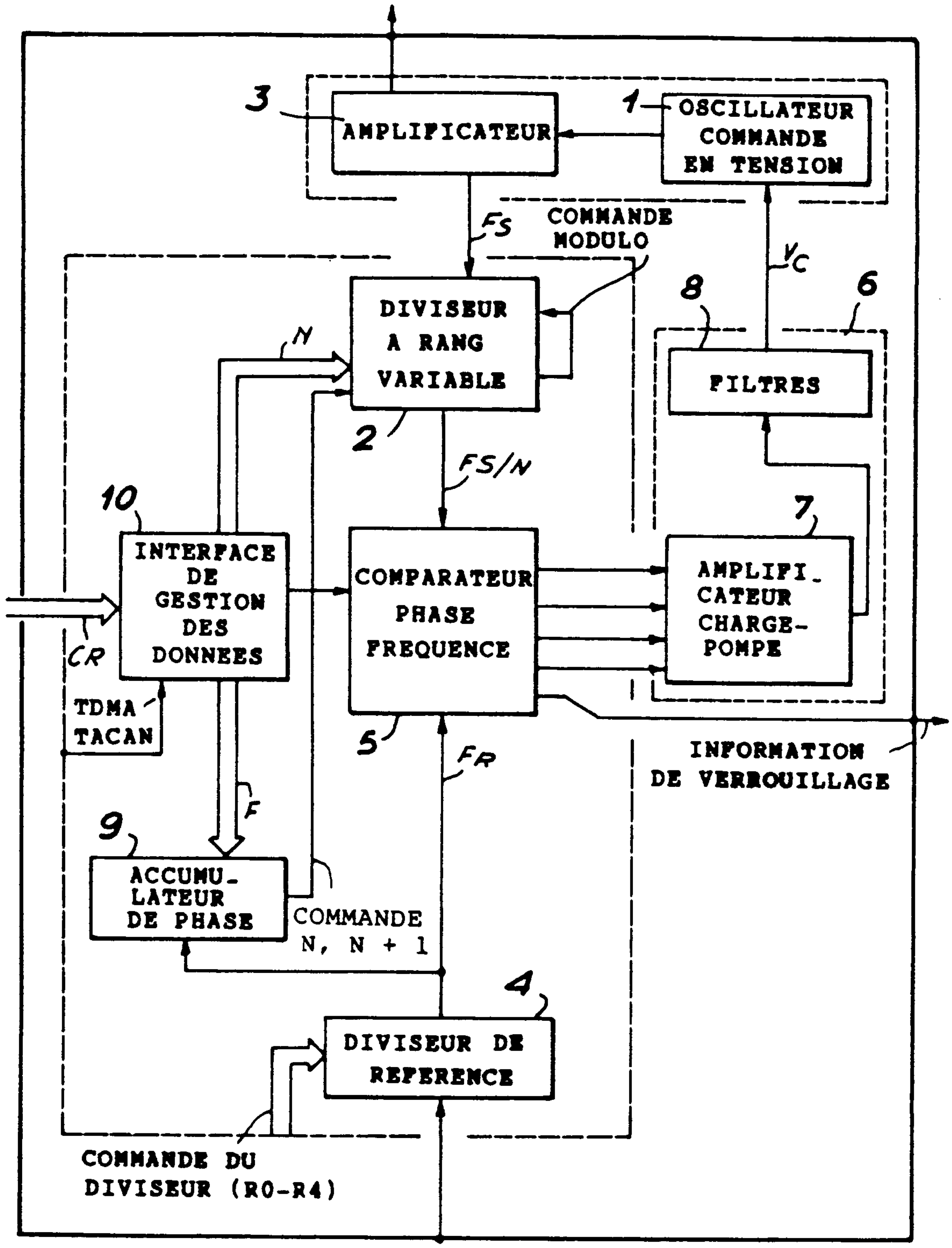
3
AMPLIFICATEUR
1
OSCILLATEUR COMMANDE EN TENSION
FS
COMMANDE MODULO
VC
8
6
DIVISEUR A RANG VARIABLE
N
2
FILTRES
FS/N
10
7
INTERFACE DE GESTION DES DONNEES
COMPARATEUR PHASE FREQUENCE
AMPLIFI_CATEUR CHARGE-POMPE
CR
TDMA TACAN
5
INFORMATION DE VERROUILLAGE
FR
F
9
ACCUMU_LATEUR DE PHASE
COMMANDE N, N + 1
4
DIVISEUR DE REFERENCE
COMMANDE DU DIVISEUR (R0-R4)

FIG. 2

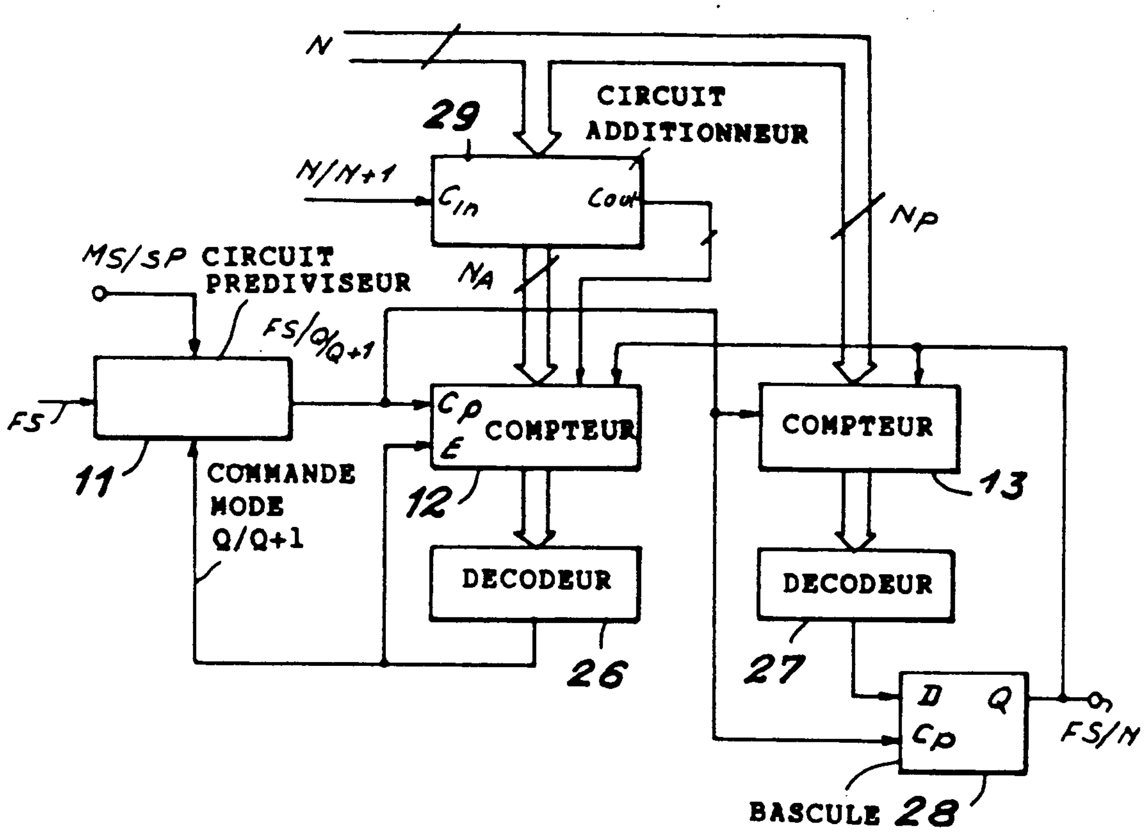
N
CIRCUIT
ADDITIONNEUR
29
N/N+1
Cin
Cout
Np
MS/SP CIRCUIT
PREDIVISEUR
NA
FS/Q/Q+1
FS
Cp
COMPTEUR
E
COMPTEUR
11
COMMANDE
MODE
Q/Q+1
12
13
DECODEUR
DECODEUR
26
27
D
Q
Cp
FS/N
BASCULE 28

FIG. 6

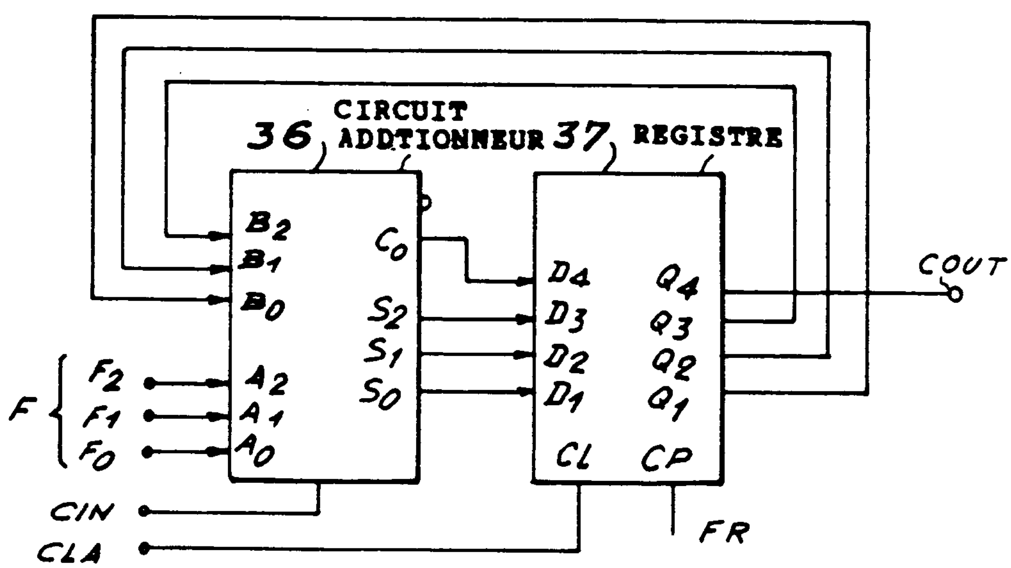
CIRCUIT
36 ADDTIONNEUR 37 REGISTRE
B2
B1
B0
Co
S2
S1
S0
F2
F1
F0
F
A2
A1
A0
D4
D3
D2
D1
Q4
Q3
Q2
Q1
COUT
CL
CP
CIN
CLA
FR

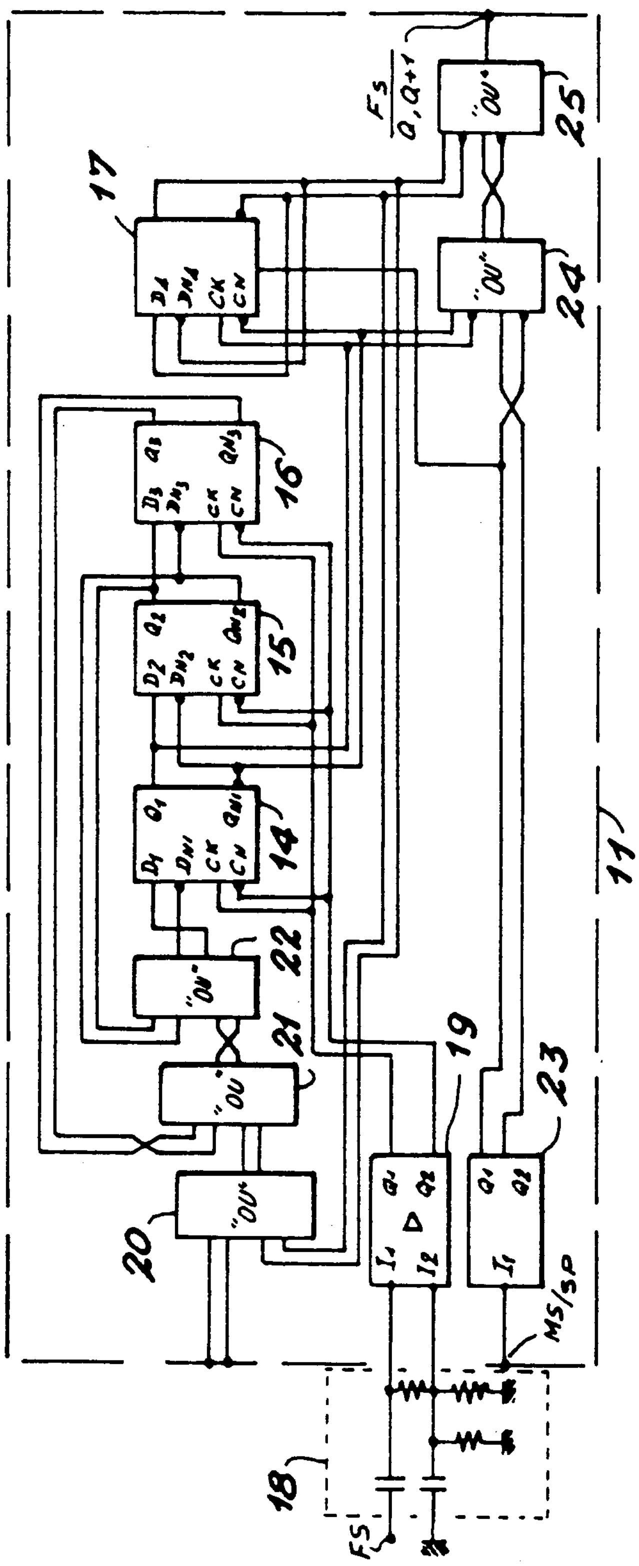

11
14
15
16
17
18
19
20
21
22
23
24
25
"OU"
FS
MS/SP


FIG. 3

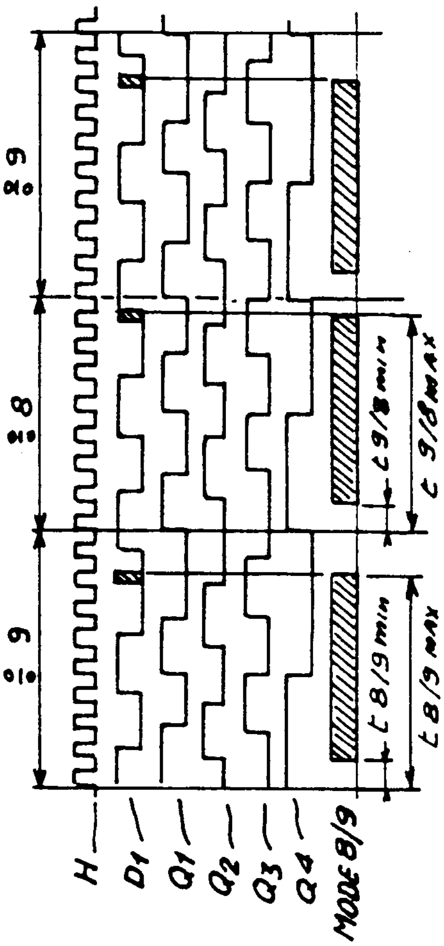

H
D1
Q1
Q2
Q3
Q4
MODE 8/9


FIG. 4

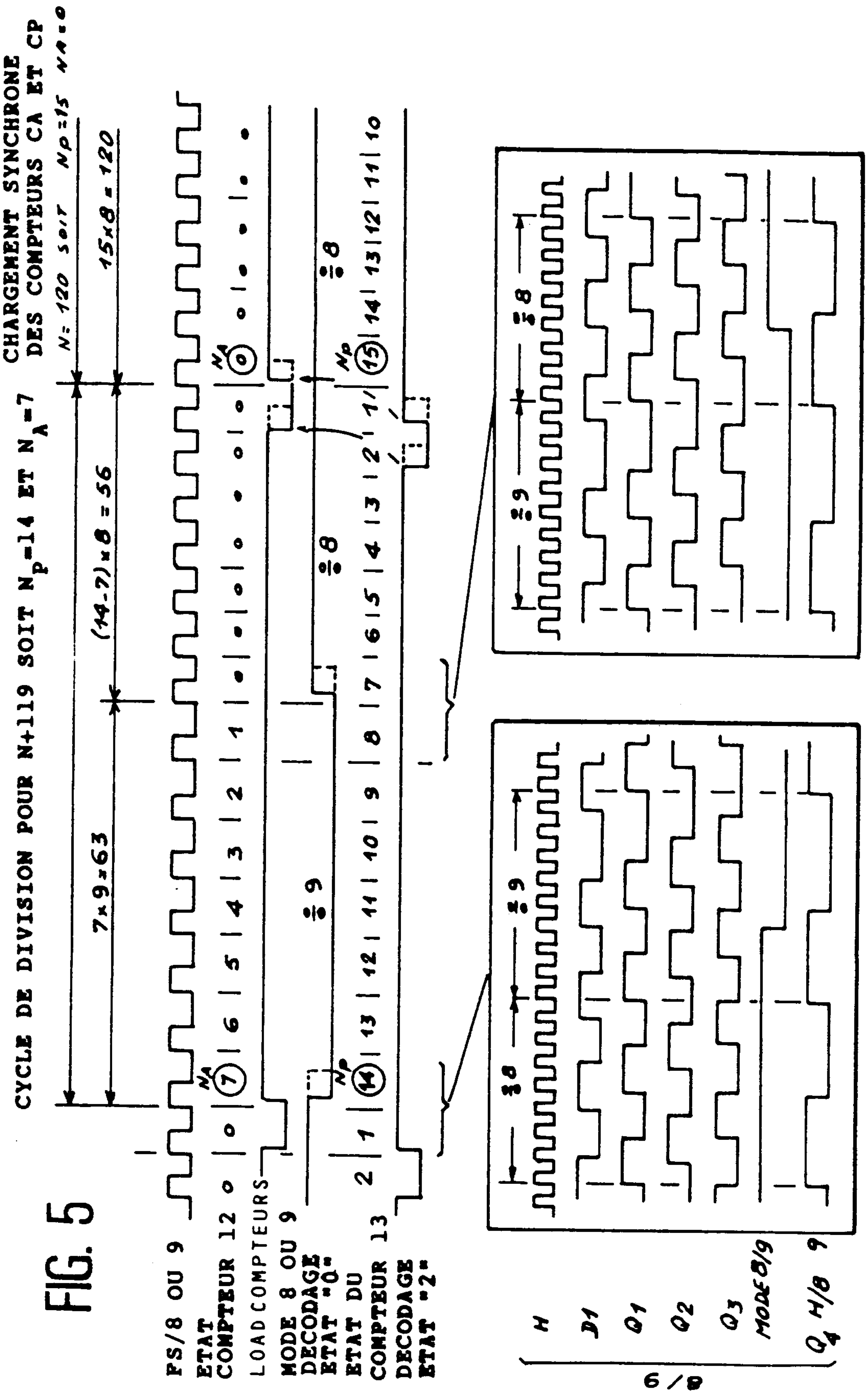
CYCLE DE DIVISION POUR N+119 SOIT $N_P$=14 ET $N_A$=7
CHARGEMENT SYNCHRONE DES COMPTEURS CA ET CP
N: 120 SOIT Np=15 NA=0
7x9=63
(14-7)x8=56
15x8=120
FS/8 OU 9
ETAT COMPTEUR 12
LOAD COMPTEURS
MODE 8 OU 9
DECODAGE ETAT "0"
ETAT DU COMPTEUR 13
DECODAGE ETAT "2"
÷9
÷8
NA
Np
H
D1
Q1
Q2
Q3
MODE 8/9
Q4 H/8 9
8/9

FIG. 5

FIG. 7

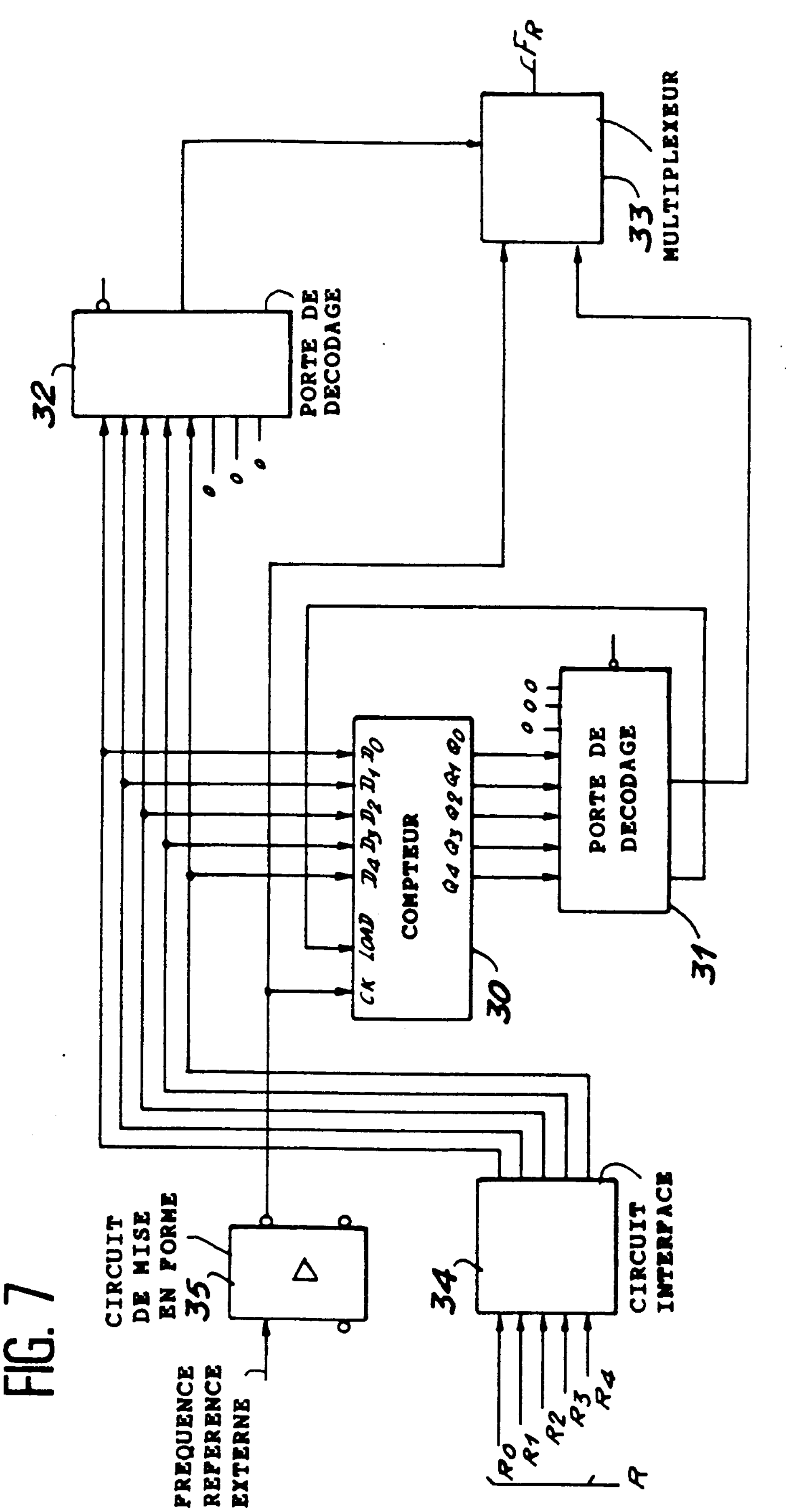

FREQUENCE REFERENCE EXTERNE
CIRCUIT DE MISE EN FORME
35
34
CIRCUIT INTERFACE
R0
R1
R2
R3
R4
R
CK
LOAD
D4 D3 D2 D1 D0
COMPTEUR
Q4 Q3 Q2 Q1 Q0
30
PORTE DE DECODAGE
31
32
PORTE DE DECODAGE
33
MULTIPLEXEUR
FR

FIG. 8

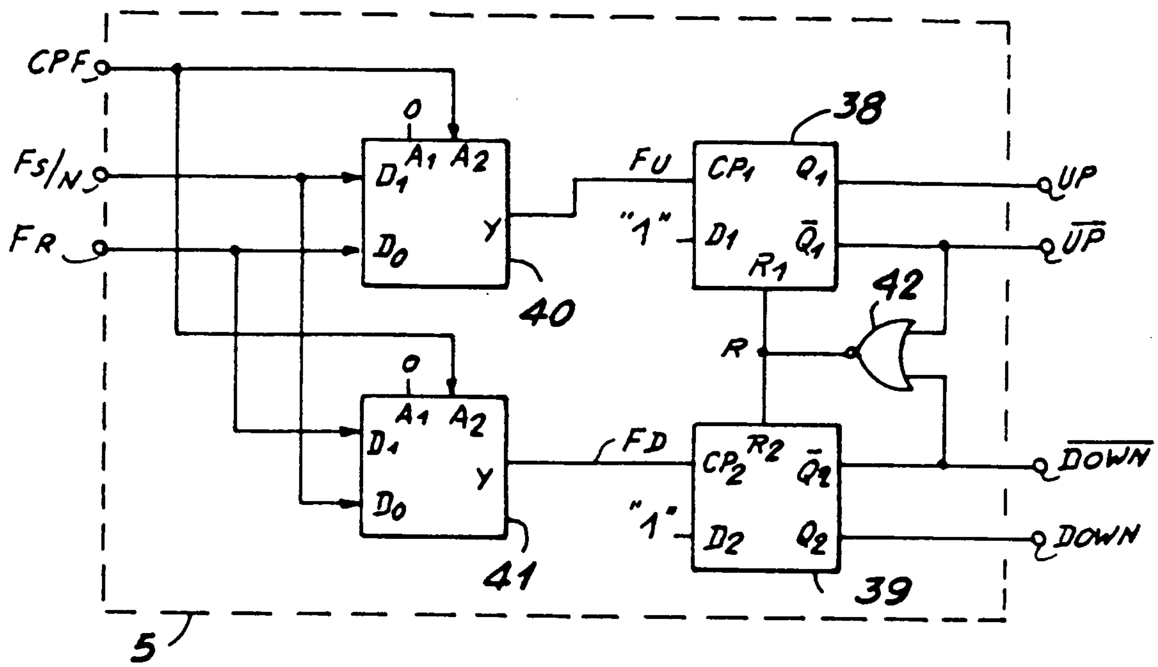


FIG. 9A

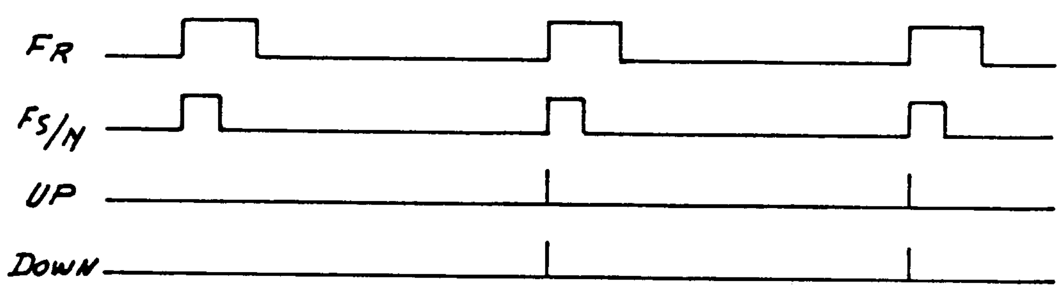


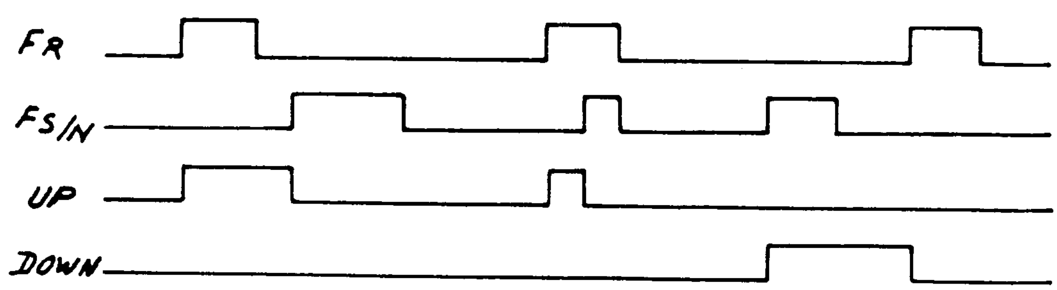


FIG. 9B

FIG. 10

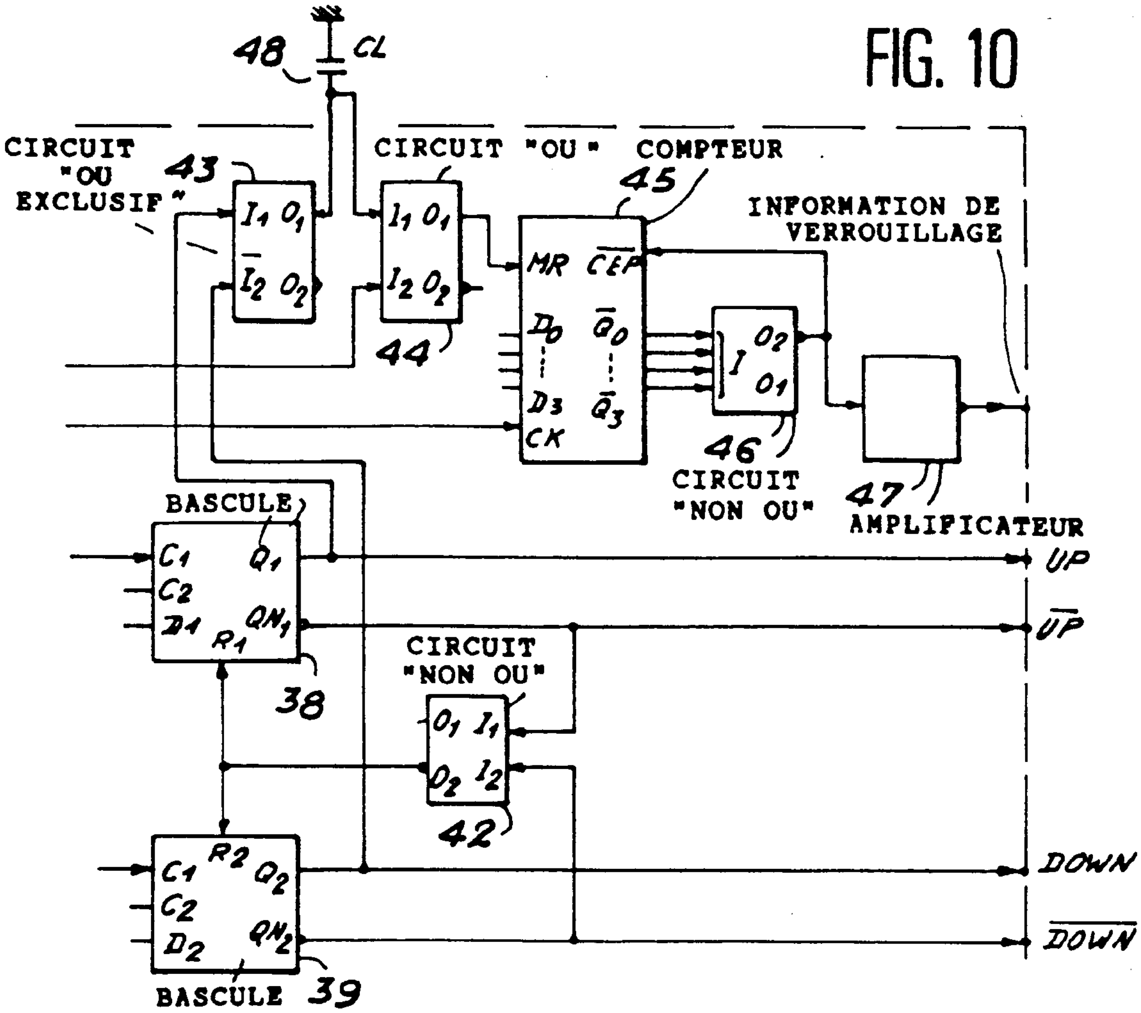
48
CL
CIRCUIT "OU EXCLUSIF"
43
CIRCUIT "OU"
COMPTEUR
45
INFORMATION DE VERROUILLAGE
44
46
CIRCUIT "NON OU"
47
AMPLIFICATEUR
BASCULE
38
CIRCUIT "NON OU"
42
BASCULE
39
UP
$\overline{UP}$
DOWN
$\overline{DOWN}$

FIG. 11

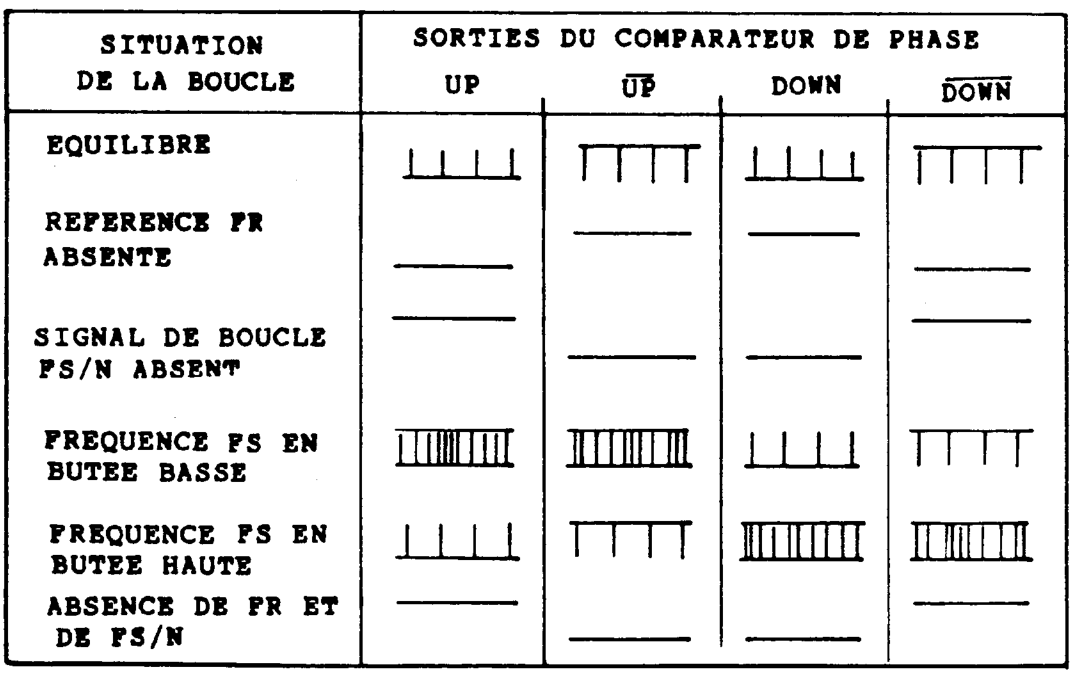
SITUATION DE LA BOUCLE
SORTIES DU COMPARATEUR DE PHASE
UP
$\overline{UP}$
DOWN
$\overline{DOWN}$
EQUILIBRE
REFERENCE FR ABSENTE
SIGNAL DE BOUCLE FS/N ABSENT
FREQUENCE FS EN BUTEE BASSE
FREQUENCE FS EN BUTEE HAUTE
ABSENCE DE FR ET DE FS/N

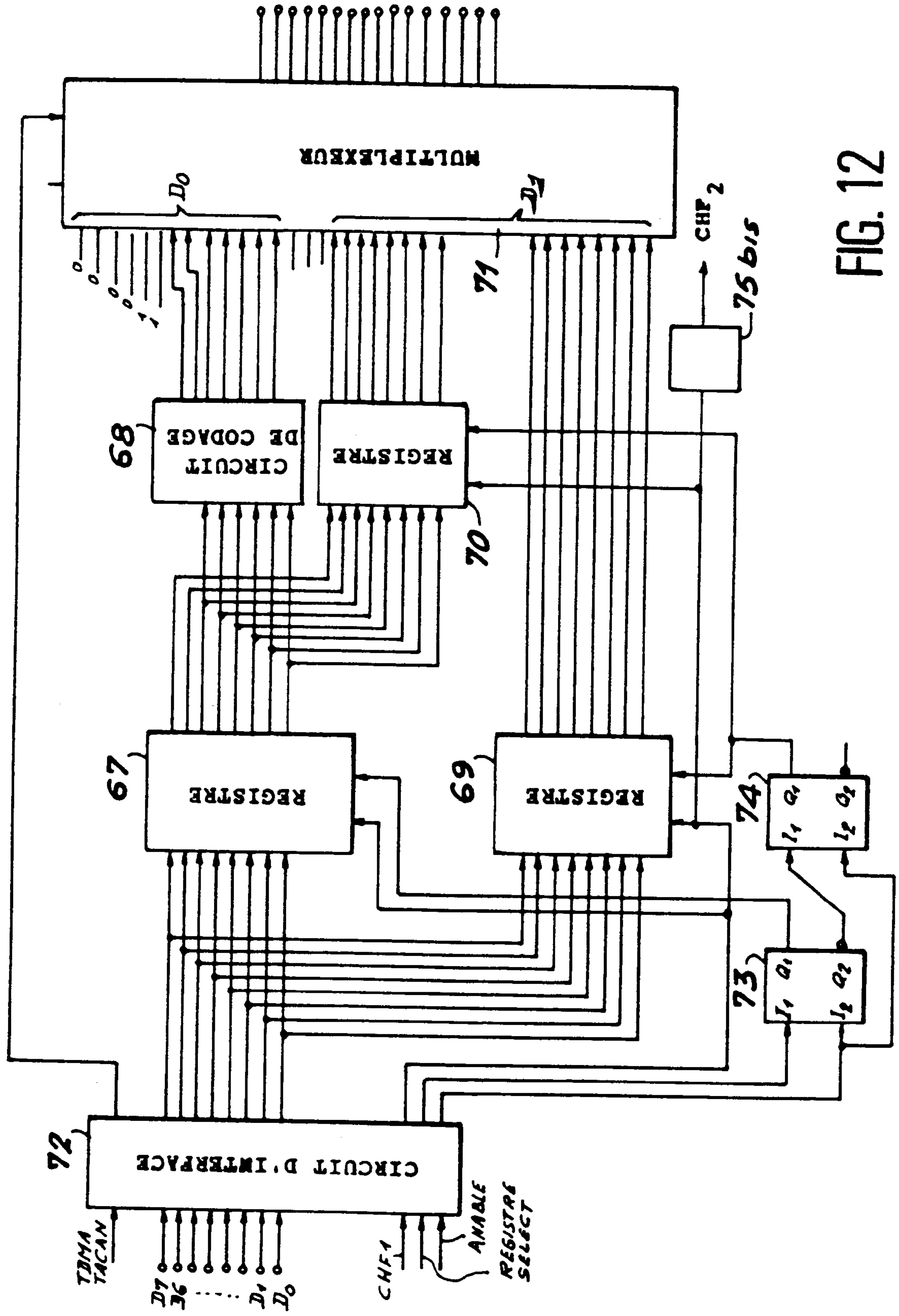
MULTIPLEXEUR
$D_0$
$D_1$
CIRCUIT DE CODAGE
68
REGISTRE
70
71
CHF 2
75 bis
REGISTRE
67
REGISTRE
69
74
73
CIRCUIT D'INTERFACE
72
TDMA TACAN
D7 D6 ..... D1 D0
CHF1
ANABLE
REGISTRE SELECT

FIG. 12

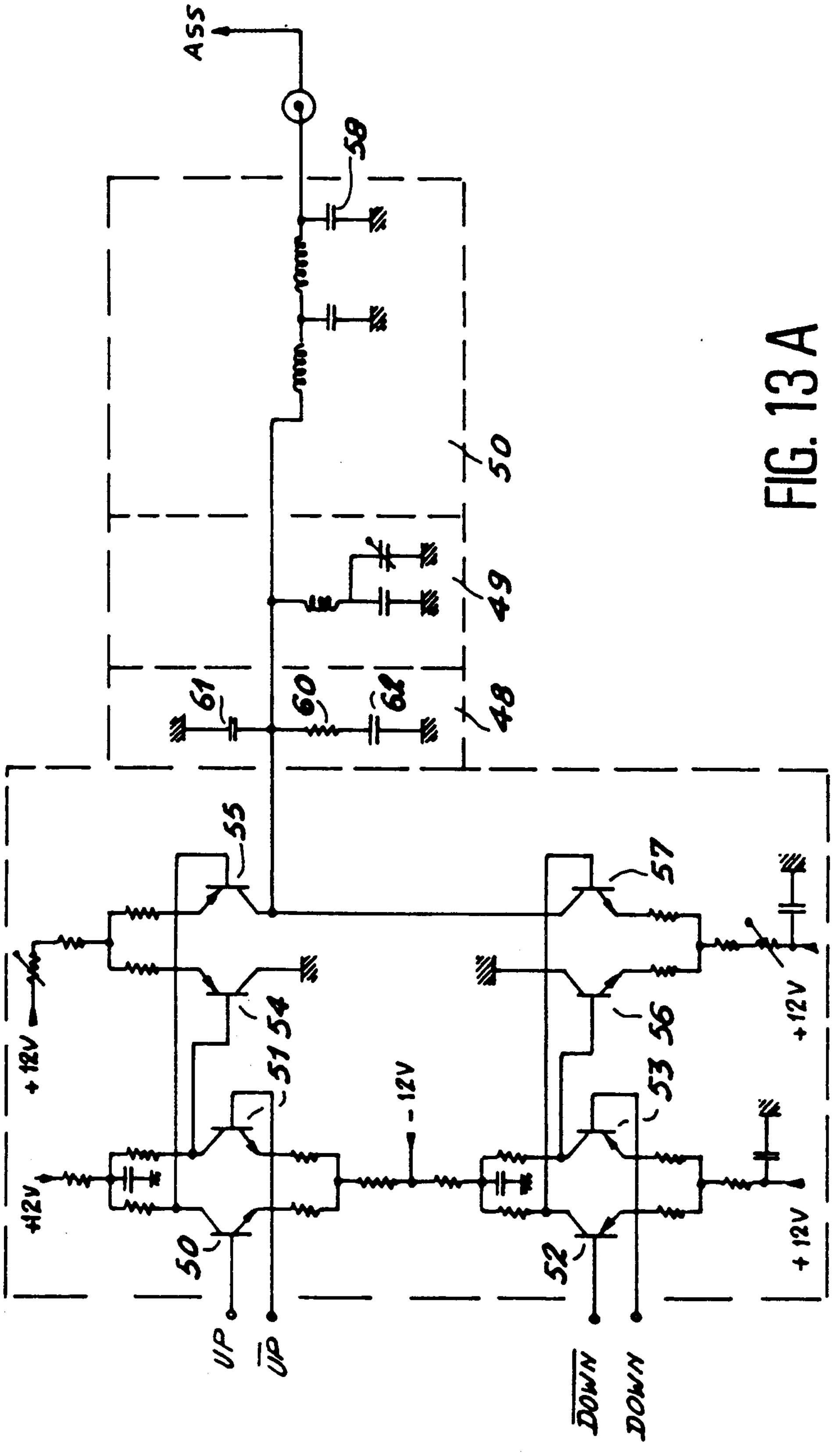
ASS
58
50
49
48
61
60
62
55
57
51
54
53
56
50
52
+12V
+12V
-12V
+12V
+12V
UP
UP
DOWN
DOWN

FIG. 13 A

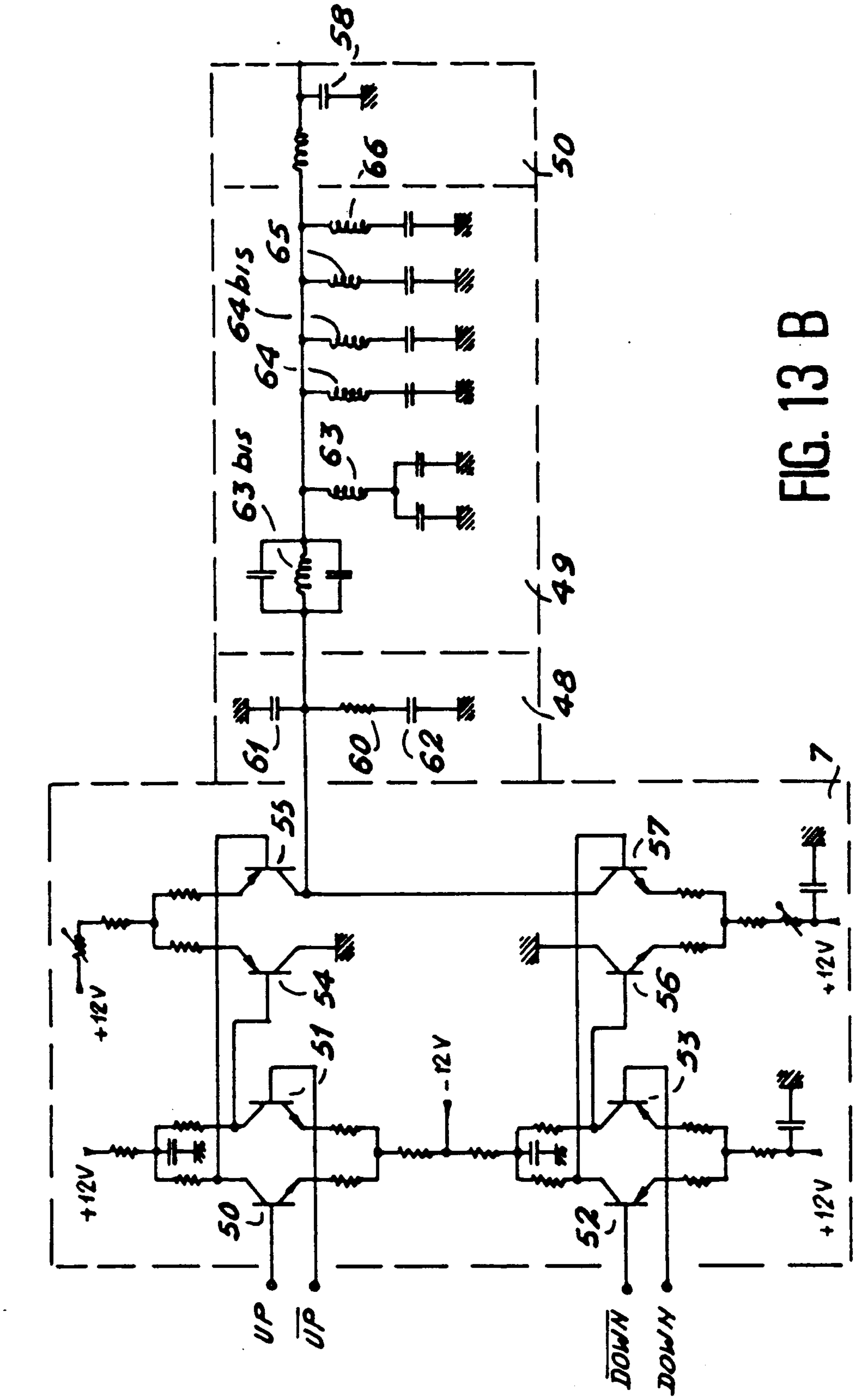
58
50
66
65
64bis
64
63 bis
63
49
48
61
60
62
7
55
57
54
56
51
53
50
52
+12V
+12V
+12V
+12V
-12V
UP
$\overline{UP}$
$\overline{DOWN}$
DOWN

FIG. 13 B

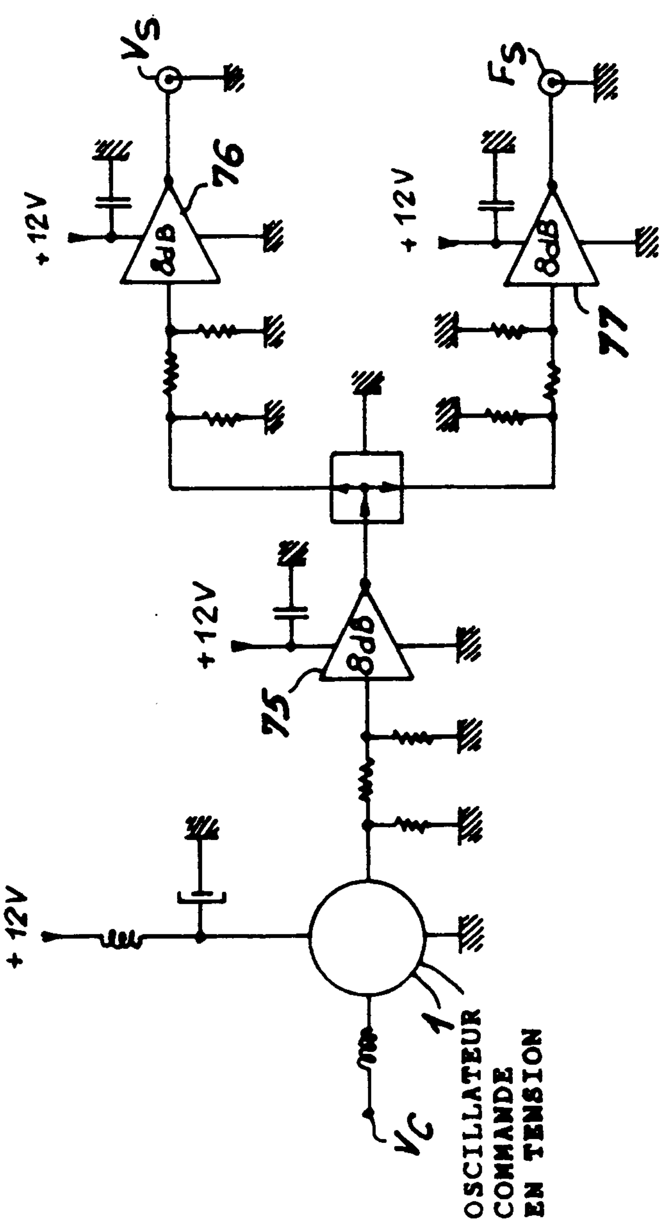


FIG. 14

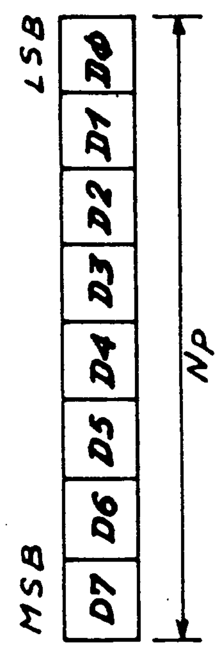


FIG. 15 A

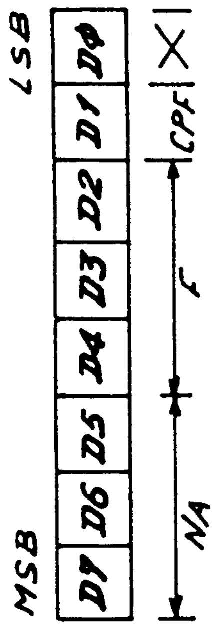


FIG. 15 B